Europäisches Patentamt

European Patent Office

Office européen des brevets

(19)

(11) Veröffentlichungsnummer: **0 240 796**
**B1**

(12) **EUROPÄISCHE PATENTSCHRIFT**

(45) Veröffentlichungstag der Patentschrift:
**04.10.89**

(51) Int. Cl.⁴: **B01J 35/04**

(21) Anmeldenummer: **87103994.7**

(22) Anmeldetag: **18.03.87**

(54) Katalysatorträger und Verfahren zur Herstellung derselben.

(30) Priorität: **08.04.86 DE 3611732**

(43) Veröffentlichungstag der Anmeldung:
**14.10.87 Patentblatt 87/42**

(45) Bekanntmachung des Hinweises auf die Patenterteilung:
**04.10.89 Patentblatt 89/40**

(84) Benannte Vertragsstaaten:
**AT CH FR GB IT LI NL SE**

(56) Entgegenhaltungen:
**EP-A- 0 207 782**

**CHEMICAL ABSTRACTS, Band 104, Nr. 2, 13. Januar 1986, Seite 215, Zusammenfassung Nr. 9160a, Columbus, Ohio, US; E.W. BECKER et al.: "Concepts of fabricating spinneret plates by synchrotron radiation lithography galvanoforming, and plastic molding" b. 1978), 303-14 000**

(73) Patentinhaber: **KERNFORSCHUNGSZENTRUM KARLSRUHE GMBH, Weberstrasse 5 Postfach 3640, D-7500 Karlsruhe 1(DE)**

(72) Erfinder: **Ehrfeld, Wolfgang, Dr., Reutstrasse 27, D-7500 Karlsruhe 41(DE)**
Erfinder: **Maner, Asim, Dr., Zwölfmorgen 8, D-7515 Linkenheim-Hochstetten 1(DE)**

## Beschreibung

Die Erfindung betrifft Katalysatorträger mit einer Grundstruktur aus Metall oder Keramik für katalytische Reaktionen zweier oder mehrerer Reaktionspartner und ein Verfahren zur Herstellung derselben.

Eine bei der Herstellung heterogener Katalysatoren besonders häufig angewandte Methode ist das Imprägnieren eines porösen Trägers mit einer Lösung, einer Schmelze oder auch einer gasförmigen Verbindung (Tränkkatalysator). Hierbei wird die katalytisch wirksame Grundsubstanz - ggf. zusammen mit einem sogenannten Promotor, durch den die katalytische Wirkung der Grundsubstanz bezüglich der Aktivität oder der Selektivität unterstützt wird - auf der Oberfläche des Trägers in feindisperser Form verteilt. Als Trägermaterialien verwendet man heute meist synthetisch hergestellte Stoffe, deren Porosität sich in weitem Umfang variieren läßt. Gebräuchliche Stoffe sind z. B. Aluminiumoxid, Silicagel, Aktivkohle, Siliziumkarbid, Titandioxid, verschiedene Silikate und Zeolithe. Zur Formgebung des Trägers sind zahlreiche Verfahren entwickelt worden. Gebräuchlich sind insbesondere das Pelletieren, das Tablettieren und das Strangpressen. Bei der Verwendung von Edelmetallkatalysatoren werden in manchen Fällen auch einfach Netze aus dünnen Edelmetalldrähten eingesetzt.

Bei der Optimierung der Struktur eines Katalysatorträgers ist eine Vielzahl von Gesichtspunkten zu beachten. Neben der Größe der gesamten Porenoberfläche, auf der die katalytisch aktive Substanz verteilt wird, spielt auch die Porenform eine entscheidende Rolle. Beispielsweise kann bei engen Poren die gewünschte Umsetzung schon innerhalb einer Strecke erreicht werden, die nur einen Bruchteil der Porentiefe ausmacht, so daß die teilweise sehr teure aktive Substanz in der Tiefe der Poren nur unvollkommen ausgenutzt wird (geringer Porennutzungsgrad). Darüber hinaus kann bei langer Verweilzeit der reagierenden Stoffe und der Reaktionsprodukte in den Poren die Selektivität der katalytischen Reaktion durch unerwünschte Folgereaktionen vermindert werden.

Insbesondere bei Reaktionen von gasförmigen Komponenten und hohen Gasdurchsätzen ist auch dem im Reaktionsraum auftretenden Druckverlust eine große Bedeutung beizumessen. Für die Autoabgas- und Industrieabgas-Entgiftung wurden deshalb spezielle Katalysatorträger entwickelt, die in Strömungsrichtung verlaufende Kanäle besitzen und als Monolithe oder Wabenkörper bezeichnet werden. Sie sind kompakte, meist zylindrisch oder oval ausgebildete, nur aus einem Stück bestehende Körper. Die im Querschnitt ersichtliche Kanalform kann dabei z. B. als Dreieck, Quadrat, Sechseck oder Kreis ausgebildet sein. In Strömungsrichtung können die Kanäle geradlinig oder wellenförmig ausgeführt sein. Als Materialien für solche Katalysatorträger werden thermisch und mechanisch hochbelastbare Stoffe verwendet, z. B. Cordierit, Mullit, Aluminiumoxid, Siliciumcarbid und Metall-Legierungen.* Die Herstellung der Katalysatorträger erfolgt durch Extrudieren oder nach dem Wickelverfahren, wobei gewellte Metallbleche oder mit keramischem Material beschichtete, gewellte Folien zu einem Wickel gerollt werden. In vielen Fällen ist die Kanaloberfläche nicht porös, sondern glatt. Vor der Belegung des Katalysatorträgers mit katalytisch wirksamer Substanz ist dann eine die Oberfläche vergrößernde Beschichtung, z. B. mit aktiver Tonerde, erforderlich. * (Ullmanns Enzyklopädie der technischen Chemie, Band 13 (1977), Seiten 560 bis 562)

Die Wirksamkeit und die Wirtschaftlichkeit eines Tränkkatalysators hängen demnach entscheidend von der geeigneten Auswahl des Katalysatorträgers und der nachfolgenden Behandlungsschritte ab. Es ist unmittelbar einsichtig, daß die Kopplung von Stoffübertragungs-, Reaktions- und Strömungsvorgängen einerseits und Probleme der mechanischen und thermischen Festigkeit andererseits berücksichtigt werden müssen und daß aus wirtschaftlicher Sicht auch der Materialaufwand, insbesondere hinsichtlich teurer Katalysatorsubstanz, eine wichtige Rolle spielt.

Aufgabe der Erfindung ist es, für unterschiedliche Zwecke verwendbare Katalysatorträger und ein Verfahren zur Herstellung derselben bereitzustellen, bei dem die vielfältigen Anforderungen an einen heterogenen Katalysator besonders flexibel erfüllt werden können. Hierbei sollen vor allem günstigere Kombinationen hinsichtlich gutem Stoffaustausch, niedrigem Druckabfall, geringerem Materialaufwand und geringerer Baugröße als bei den bekannten Katalysatorträgern erreicht werden.

Die Aufgabe wird durch Katalysatorträger nach Anspruch 1 gelöst. Vorteilhafte Ausbildungen des erfindungsgemäßen Katalysatorträgers sind in den Unteransprüchen 2 bis 4 offenbart. Der die Herstellung des Katalysatorträgers betreffende Teil der Aufgabe wird durch das im Kennzeichen des Anspruchs 5 beschriebene Verfahren gelöst. Vorteilhafte Weiterbildungen des erfindungsgemäßen Verfahrens finden sich in den Kennzeichen der Unteransprüche 6 bis 10. Als Katalysatorträger kann auch ein Mikrostrukturkörper, wie er in Anspruch 1 charakterisiert ist, verwendet werden.

Die Herstellung von Mikrostrukturkörpern nach dem LIGA-Verfahren ist u.a. in dem KfK-Bericht 3995 des Kernforschungszentrums Karlsruhe (November 1985) beschrieben und dargestellt. Danach wird z.B. ein röntgenstrahlenempfindlicher Positiv-Resist auf eine metallische Grundplatte aufgebracht und partiell über eine Maske mit Röntgenstrahlen so bestrahlt und entwickelt, daß Negativformen von plattenförmigen Mikrostrukturkörpern entstehen. Die Höhe der Negativform entspricht der Schichtdicke des Resists; sie kann, je nach Eindringtiefe der Röntgenstrahlung bis zu 2 mm betragen. Anschließend wird die Negativform galvanisch mit einem Metall unter Verwendung der Grundplatte als Elektrode aufgefüllt, worauf das restliche Resistmaterial mit einem Lösungsmittel entfernt wird. Bei der Abformtechnik wird eine durch Röntgentiefenlithographie und Mikrogalvanoformung hergestellte Metallstruktur zur vielfachen Herstellung von Kunststoff-Formen verwendet, die wiederum z. B. durch galvanische Abscheidung von Metall aufgefüllt werden können, worauf dann der Kunststoff wieder entfernt wird.

Mit dieser Technik lassen sich extrem genaue und feine Strukturen herstellen mit lateralen Abmessungen im Mikrometerbereich bei einer frei wählbaren Höhe bis zu ca. 2 mm. Bei etwas geringeren Höhen lassen sich auch minimale laterale Abmessungen im Submikrometerbereich realisieren.

Die mit dieser Technik erzeugten plattenförmigen Mikrostrukturkörper für den Aufbau von Katalysatorträgern können beispielweise Platten mit einer Vielzahl von Löchern, z. B. in Form von Sechsecken, sein. Gleichermaßen können Platten mit bis zu 2 mm hohen Stegen von wenigen Mikrometern Breite und nahezu beliebiger Länge erzeugt werden. Durch die Möglichkeit zur freien Formgestaltung der Löcher bzw. der Stege oder der sonstigen Strukturen der plattenförmigen Mikrostrukturkörper kann optimal den Gesichtspunkten des intensiven Stofftransports aus der fluiden Phase zur festen Wand und den Forderungen nach möglichst geringem Druckverlust beim Durchströmen des aus den Mikrostruktur-Körpern aufgebauten Katalysatorträger Rechnung getragen werden.

Wegen der geringen Abmessungen der Löcher bzw. der Stege läßt sich ein günstiges Verhältnis von Oberfläche zu Volumen des Katalysatorträgers bereits ohne zusätzliche Maßnahmen zur Oberflächenvergrößerung erzielen. Gegenüber den bekannten, eingangs erwähnten Edelmetallnetzen wird bereits so eine Verbesserung des Wirkungsgrades erzielt, da bei gleichzeitiger Vergrößerung der spezifischen Katalysatoroberfläche eine Erhöhung der Transparenz, d. h. des frei durchströmbaren Anteils der Querschnittsfläche, und so eine Verminderung des Druckabfalls möglich ist. Bei der Verwendung von Edelmetallen können hier Träger und katalytisch wirksame Substanz identisch sein.

In einer vorteilhaften Weiterbildung der Erfindung werden gemäß Anspruch 6 die plattenförmigen Mikrostrukturen vor dem Imprägnieren mit katalytisch wirksamer Substanz mit einem die Oberfläche vergrößernden Stoff, z. B. mit aktiver Tonerde, belegt. Eine Belegung kann außerdem durch bekannte Methoden der Dünnfilmtechnik, wie Chemical Vapor Deposition (CVD) oder Physical Vapor Deposition (PVD) erfolgen, wobei die Belegung ggf. durch einen weiteren Prozeß mikroporös gemacht wird. Ein Beispiel hierfür ist die Beschichtung mit Aluminium durch Aufdampfen und die anschließende Oxidation der aufgedampften Aluminiumschicht. Ein besonderer Vorteil dieser Methode besteht darin, daß einerseits von vornherein bereits durch die große Zahl der einzelnen Mikrostrukturen auf dem Mikrostrukturkörper eine vergleichsweise große Oberfläche vorgegeben wird und daß andererseits durch Belegung dieser Oberfläche mit einer porösen Schicht die Oberfläche weiter vergrößert werden kann, wobei die Struktur und Tiefe der Poren durch die Erzeugung und Nachbehandlung der Schicht in definierter Weise vorgegeben werden können.

Eine weitere vorteilhafte Möglichkeit zur Vergrößerung der Oberfläche der Mikrostrukturkörper besteht gemäß Anspruch 7 darin, daß bei der Mikrogalvanoformung Mikrostrukturkörper aus einer Metall-Legierung oder einer mikrodisperse Teilchen enthaltenden Metallmatrix erzeugt werden und daß anschliessend Bestandteile aus der Metall-Legierung bzw. aus der Metallmatrix, z. B. durch Auflösen oder durch Erhitzen, entfernt werden. Auf diese Weise werden Katalysatorträger mit hoher aktiver Oberfläche erzeugt, die den bekannten Skelett-Katalysatoren entsprechen.

Durch die Verwendung von Formmassen, die aus feinem Keramik- und/oder Metallpulver sowie einem Bindemittel bestehen, lassen sich gemäß Anspruch 8 plattenförmige Mikrostrukturkörper direkt als Sinterkörper mit entsprechend großer katalytisch wirksamer Oberfläche herstellen. Dabei ist es möglich, entweder eine nach dem Abformprozeß hergestellte Negativform mit der oben genannten Formmasse aufzufüllen oder den Mikrostrukturkörper mit einem Werkzeug, dessen Form dem Negativ des gewünschten Mikrostrukturkörpers entspricht, unter Verwendung der o. g. Formmasse zu erzeugen. Hierbei werden zweckmäßigerweise der Formmasse weitere Stoffe als Gleitmittel und als Trennmittel beigefügt durch die das Auffüllen der Werkzeugs mit Formmasse und die anschließende Entformung des ausgehärteten Mikrostrukturkörpers erleichtert wird. Der entformte, ausgehärtete Mikrostrukturkörper wird üblicherweise einer Wärmebehandlung unterzogen, wobei das Bindemittel entfernt und der Mikrostrukturkörper durch Sinterung verfestigt wird.

Eine besonders einfach Möglichkeit zur Vergrößerung der Oberfläche der plattenförmigen Mikrostrukturkörper besteht darin, daß zur Herstellung des Negativs eine Formmasse aus mehreren Bestandteilen verwendet wird. Geeignet ist beispielsweise eine Formmasse aus Styrol, Divinylbenzol und Polyvinylacetat. Bei der Copolymerisation von Styrol und Divinylbenzol, die zusätzlich vernetzt werden, wird Polyvinylacetat als inerte Komponente eingebaut und kann anschließend herausgelöst werden, wobei ein Copolymer mit permanenter Porosität entsteht. Durch Einbringen der bereits oben erwähnten Formmasse, die aus einem Keramikpulver und/oder einem Metallpulver mit einem Bindemittel besteht, in das poröse Negativ des Mikrostrukturkörpers wird ein Mikrostrukturkörper mit großer Oberfläche erzeugt. Gleichermaßen kann durch Mikrogalvanoformung ein Mikrostrukturkörper aus Metall erzeugt werden, der entsprechend der porösen Wandstruktur des Negativs eine entsprechend vergrößerte Oberfläche aufweist.

Die Erfindung wird im folgenden anhand der Zeichnungen näher erläutert:

Die Figuren 1 - 3 und 5 - 8 zeigen die Herstellung der Mikrostrukturkörper, wobei zur Vereinfachung jeweils nur wenige Mikrostrukturen dargestellt sind.

Die Figuren 4 und 9 - 12 zeigen einige typische Formen von erfindungsgemäß hergestellten Katalysatorträgern in schematischer Darstellung und veranschaulichen die vielfältigen Möglichkeiten der Formgebung.

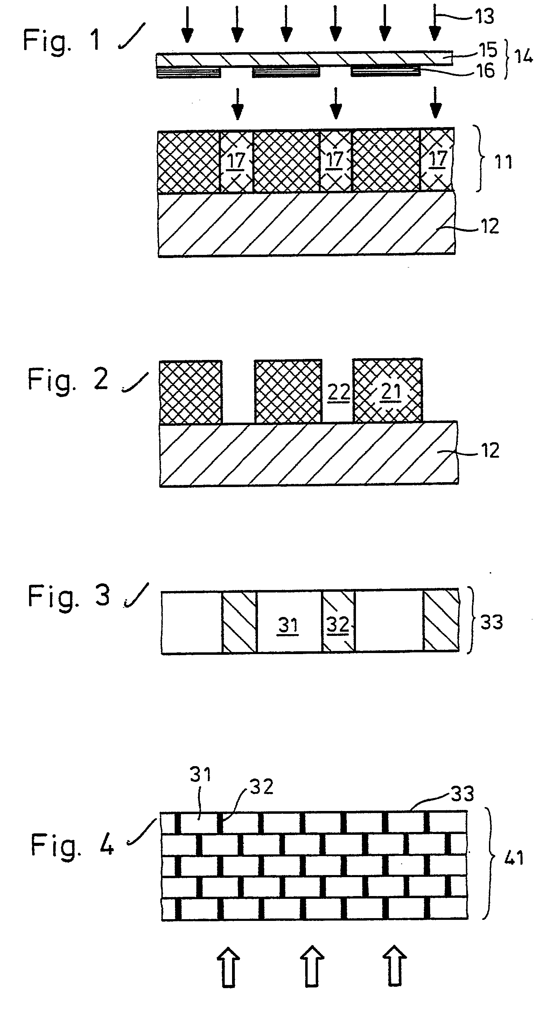

Figur 1 zeigt im Schnitt eine metallische Schicht 12, auf der eine Schicht 11 aus einem durch Röntgenstrahlung in seinen Eigenschaften veränderbaren Kunststoff (Resist) aufgebracht wurde. Durch partielles Bestrahlen mit Synchrotronstrahlung 13 über eine Röntgenmaske 14, die aus einer für Röntgenstrahlung weitgehend transparenten Trägerfolie 15 und Absorberstrukturen 16 besteht, werden die bestrahlten Bereiche 17 der Resistschicht 11 strahlenchemisch verändert, wobei ihre Löslichkeit erhöht wird. Durch Auflösen der Bereiche 17 entsteht eine reliefartige Mikrostruktur 21 aus Kunststoff mit freien Bereichen 22 gemäß Figur 2. Diese freien Bereiche 22 werden durch galvanische Abscheidung von Metall aufgefüllt, wonach die Mikrostruktur 21 aus Kunststoff und die metallische Schicht 12 entfernt werden. Gemäß Figur 3 entsteht dabei ein aus Durchbrüchen 31 und Wänden 32 bestehender plattenförmiger Mikrostrukturkörper 33. Solche Mikrostrukturkörper werden gemäß Figur 4 aufeinandergeschichtet, ausgerichtet und zu einem stabilen Körper 41 verbunden, der den Katalysatorträger darstellt. Die Wände 32 der Durchbrüche 31 werden bei der Ausrichtung der Mikrostrukturkörper gegeneinander versetzt, um den Stofftransport auf die Wand, die mit katalytisch wirksamer Grundsubstanz beschichtet wird, zu verbessern. Die Pfeile kennzeichnen die Hauptströmungsrichtung der Reaktionspartner.

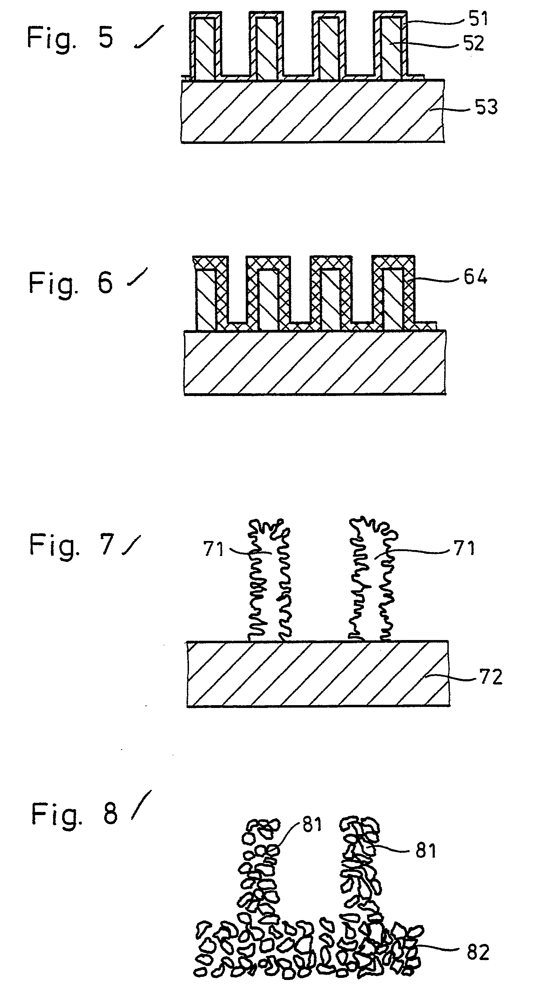

Zur Vergrößerung der katalytisch wirksamen Oberfläche werden gemäß Figur 5 die Wände der auf einer Grundplatte 53 angebrachten Mikrostrukturen 52, die beispielsweise als in Strömungsrichtung verlaufende oder gegenüber der Strömungsrichtung angestellte Rippen ausgebildet sind, mit einem Stoff 51 beschichtet. Durch einen chemischen Prozeß wird die Schicht 51 in eine mikroporöse Belegung 64 umgewandelt. (Fig. 6).

In Figur 7 sind schematisch mikroporöse Strukturen 71 dargestellt, wie sie durch Abscheiden einer Metall-Legierung auf eine Trägerplatte 72 und anschließendes Herauslösen eines Legierungsbestandteiles erzeugt werden können (Skelett-Katalysator). In Figur 8 ist schematisch der Aufbau von Mikrostrukturen 81 auf einer Grundplatte 82 dargestellt, wobei die Formgebung der plattenförmigen Mikrostrukturkörper mit Hilfe des Abformverfahrens erfolgte, die Formmasse ein Keramikund/oder Metallpulver mit einem Bindemittel enthielt und nach der Verfestigung der Formmasse ein Sinterprozeß angeschlossen wurde.

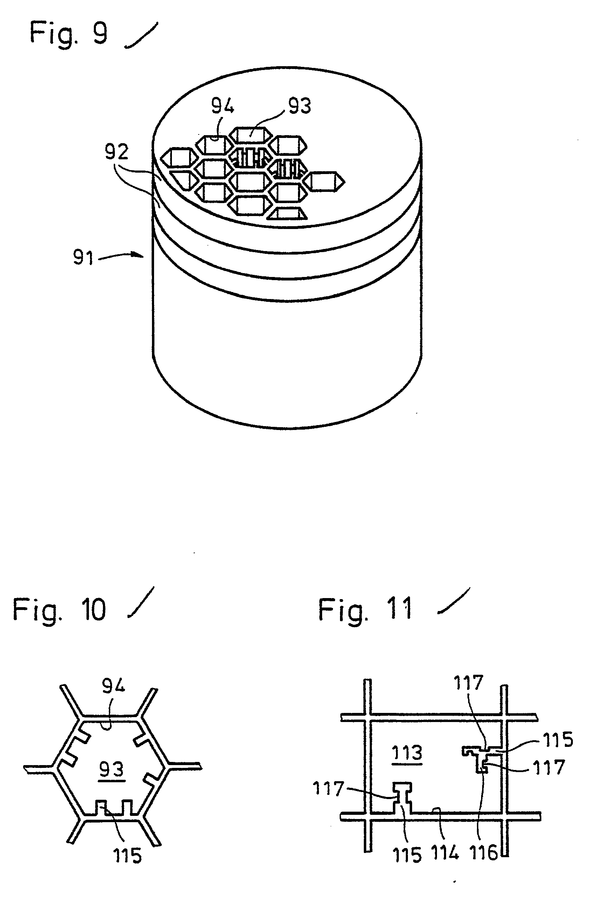

In Figur 9 ist ein Figur 4 entsprechender Katalysatorträger 91, der aus gegeneinander ausgerichteten, plattenförmigen Mikrostrukturkörpern 92 aufgebaut ist dargestellt. Die Kanalwände 94 der Kanäle 93 weisen in die Kanäle hineinragende Rippen 115 auf, wie aus Figur 10 hervorgeht. In Figur 11 ist ein Kanal 113 mit rechteckigem Querschnitt dargestellt. Die Kanalwände 114 weisen Primärrippen 115 mit Sekundärrippen 116 und Vertiefungen 117 auf.

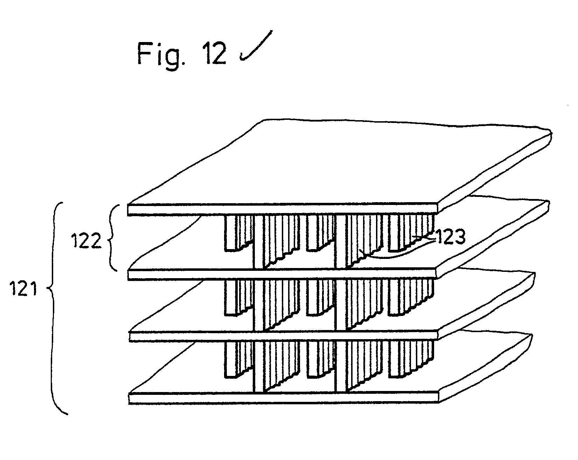

In Figur 12 ist ein Stapel von plattenförmigen Mikrostrukturkörpern 122 dargestellt, die zusammengefügt den Katalysatorträger 121 bilden. Auf den Mikrostrukturkörpern sind Rippen 123 angebracht, die zur Vergrößerung der Oberfläche, zur Erhöhung der Stabilität und zur Verbesserung des Stofftransports gewellt und gegeneinander versetzt ausgeführt sind.

Es sei ausdrücklich darauf hingewiesen, daß der Umfang der Erfindung die Verwendung einzelner Mikrostrukturkörper als Katalysatorträger einschließt. Die Erfindung schließt außerdem natürlich auch solche Katalysatorträger ein. bei denen erfindungsgemäß hergestellte Mikrostrukturkörper mit auf Grundplatten aufgebrachten Rippen zu einem kompakten Katalysatorträger gewickelt werden.

**Patentansprüche**

1. Katalysatorträger mit einer Grundstruktur aus Metall oder Keramik für katalytische Reaktionen zweier oder mehrerer Reaktionspartner, hergestellt aus einzelnen, plattenförmigen, aufeinandergeschichteten, ausgerichteten und zu einem stabilen Körper zusammengefügten Mikrostrukturkörpern, die nach einem Verfahren der Röntgentiefenlithographie-Mikrogalvanoformung oder nach der hiervon abgeleiteten Mikroabformtechnik (LIGA-Verfahren) erzeugt wurden, wobei im stabilen Körper Kanäle ausgebildet sind.

2. Katalysatorträger nach Anspruch 1, dadurch gekennzeichnet, daß die Kanalwände in die Kanäle hineinragende Rippen (Primärrippen) aufweisen.

3, Katalysatorträger gemäß Anspruch 2, dadurch gekennzeichnet, daß die Primärrippen ihrerseits mit Rippen und/oder Vertiefungen versehen sind.

4. Katalysatorträger nach Anspruch 1, dadurch gekennzeichnet, daß auf den plattenförmigen Mikrostrukturkörpern gegeneinander versetzte, gewellte Rippen aufgebacht sind.

5. Verfahren zur Herstellung von Katalysatorträgern, dadurch gekennzeichnet, daß einzelne nach einem Verfahren der Röntgentiefenlithographie-Mikrogalvanoformung oder nach der hiervon abgeleiteten Mikroabformtechnik (LIGA- Verfahren) hergestellte plattenförmige Mikrostrukturkörper aufeinandergeschichtet, ausgerichtet und zu einem stabilen Körper zusammengefügt werden.

6. Verfahren nach Anspruch 5, dadurch gekennzeichnet, daß die plattenförmigen Mikrostrukturkörper vor dem Imprägnieren mit katalytisch wirksamer Substanz mit einem die Trägeroberfläche vergrößernden Stoff, z. B. mit aktiver Tonerde, belegt werden.

7. Verfahren nach Anspruch 5, dadurch gekennzeichnet, daß bei der Mikrogalvanoformung Mikrostrukturkörper aus einer Metall-Legierung oder einer mikrodisperse Teilchen enthaltenden Metallmatrix erzeugt werden und daß anschliessend Bestandteile aus der Metall-Legierung bzw. aus der Metallmatrix, z. B. durch Auflösen oder durch Erhitzen, entfernt werden.

8. Verfahren nach Anspruch 5, dadurch gekennzeichnet, daß die plattenförmigen Mikrostrukturkörper durch Mikroabformtechnik unter Verwendung einer Formmasse hergestellt werden, die aus hochdispersen keramischen und/oder metallischen Bestandteilen und einem Bindemittel besteht, und daß das Bindemittel nach dem Festwerden der Formteile, z. B. durch Erhitzen, entfernt wird.

9. Verfahren nach Anspruch 5 bis 8 dadurch gekennzeichnet, daß bei der Herstellung der Formen für die plattenförmigen Mikrostrukturkörper eine Formmasse aus mehreren Bestandteilen verwendet und mindestens ein Bestandteil vor dem Aufbau des Mikrostrukturkörpers entfernt oder chemisch umgewandelt wird.

10. Verfahren nach Anspruch 5, dadurch gekennzeichnet, daß ein oder mehrere Mikrostrukturkörper mit auf Grundplatten aufgebrachten Rippen zu einem kompakten Katalysatorträger gewickelt werden.

11. Verwendung eines Mikrostrukturkörpers nach Anspruch 1 als Katalysatorträger.

**Claims**

1. Catalyst support having a basic structure of metal or ceramics for catalytic reactions of two or more reaction partners produced from individual plate-like microstructural bodies, which are situated one above the other in layers and are aligned with one another, said bodies being combined to form a stable body and being produced by a method of low-level radiolithography-cum-microgalvanic moulding or by the microdeforming technique derived therefrom (LIGA method), wherein channels are formed in the stable body.

2. Catalyst support according to claim 1, characterised in that the channel walls have ribs (primary ribs) protruding into the channels.

3. Catalyst support according to claim 2, characterised in that the primary ribs, in turn, are provided with ribs and/or indentations.

4. Catalyst support according to claim 1, characterised in that corrugated ribs, which are offset relative to one another, are provided on the plate-like microstructural bodies.

5. Method of producing catalyst supports, characterised in that individual plate-like microstructural bodies, produced by a method of low-level radiolithographycum-microgalvanic moulding or by the microdeforming technique derived therefrom (LIGA method), are situated one above the other in layers, are aligned with one another and are combined to form a stable body.

6. Method according to claim 5, characterised in that, prior to being impregnated with a catalytically active substance, the plate-like microstructural bodies are coated with a substance which increases the support surface, e.g. with active alumina.

7. Method according to claim 5, characterised in that, during microgalvanic moulding, microstructural bodies are produced from a metal alloy or a metal matrix containing microdispersed particles, and in that substances are subsequently removed from the metal alloy, or respectively from the metal matrix, e.g. by resolution or by heating.

8. Method according to claim 5, characterised in that the plate-like microstructural bodies are produced by a microdeforming technique, utilising a moulding material which is formed from highly dispersed, ceramic and/ormetallic substances and a bonding agent, and in that the bonding agent is removed after the moulded parts have solidified, e.g.

by heating.

9. Method according to claims 5 to 8, characterised in that, during production of the moulds for the plate-like microstructural bodies, a moulding material formed from a plurality of substances is used, and at least one substance is removed or chemically converted prior to the formation of the microstructural body.

10. Method according to claim 5, characterised in that one or more microstructural bodies, having ribs provided on base plates, are wound to form a compact catalyst support.

11. Use of a microstructural body according to claim 1 as a catalyst support.

**Revendications**

1. Supports de catalyseur comprenant une structure de base en métal ou céramique pour réaliser des réactions catalytiques de deux ou plusieurs partenaires de réaction, préparés à partir de corps microstructuraux individuels, en forme de plaques, empilés et alignés et assemblés pour donner un corps stable, qui ont été préparés selon un procédé de lithographie par rayons X et microgalvanoplastie ou selon la technique de micromoulage qui en est dérivée (procédé LIGA), en formant des canaux dans des corps stables.

2. Supports de catalyseur selon la revendication 1, caractérisés en ce que les parois de canal présentent des nervures (nervures primaires) qui émergent dans les canaux.

3. Supports de catalyseur selon la revendication 2, caractérisés en ce que les nervures primaires sont munies à leur tour de nervures et/ou de creux.

4. Supports de catalyseur selon la revendication 1, caractérisés en ce que sur les corps à microstructure sont disposées des nervures ondulées, en quinconce.

5. Procédé de préparation de supports de catalyseur, caractérisé en ce que les corps individuels à microstructure en forme de plaque, préparés selon un procédé de lithographie par rayons X et microgalvanoplastique ou selon le procédé de micromoulage qui en dérive (procédé LIGA), sont empilés, alignés et rassemblés en un corps stable.

6. Procédé selon la revendication 5, caractérisé en ce que les corps à microstructure en forme de plaque sont enduits, avant l'imprégnation avec la substance catalytiquement active, d'un matériau qui augmente la surface du support, par exemple une alumine active.

7. Procédé selon la revendication 5, caractérisé en ce que lors de la formation par microgalvanoplastie, on prépare des corps à microstructure, en alliage métallique ou en matrice de métal contenant des particules microdispersées, et qu'ensuite des composants de l'alliage métallique ou bien de la matrice métallique sont éliminés, par exemple par dissolution ou par chauffage.

8. Procédé selon la revendication 5, caractérisé en ce que les corps à microstructure en forme de plaque sont préparés par technique de micromoulage en utilisant une masse à mouler qui est constituée de composants céramiques et/ou métalliques hautement dispersés et d'un liant, et que le liant est éliminé après solidification des pièces moulées, par exemple par chauffage.

9. Procédé selon les revendications 5 à 8, caractérisé en ce que, pour la préparation des moules pour les corps à microstructure, on utilise une masse à mouler constituée de plusieurs composants et qu'on élimine au moins un composant avant la réalisation du corps à microstructure ou on le transforme chimiquement.

10. Procédé selon la revendication 5, caractérisé en ce qu'on empile un ou plusieurs corps à microstructure avec des nervures disposées sur des plaques de base pour réaliser un support compact de catalyseur.

11. Utilisation d'un corps à microstructure selon la revendication 1 comme support de catalyseur.

Fig. 1

13
15 } 14
16
17  17  17  } 11
12

Fig. 2

22  21
12

Fig. 3

31  32  } 33

Fig. 4

31  32  33
41

Fig. 5

51
52
53

Fig. 6

64

Fig. 7

71
71
72

Fig. 8

81
81
82

Fig. 9

94 93

92

91

Fig. 10

94

93

115

Fig. 11

117

113

115

117

117

115 114 116

Fig. 12